# EUROPEAN PATENT APPLICATION

(11) **EP 4 580 324 A1**
(43) Date of publication of application: **02.07.2025**
(21) Application number: 24834226.3
(22) Date of filing: 01.11.2024
(51) Int. Cl.: H05K 7/14, H05K 7/20, H04M 1/02

(54) **ELECTRONIC DEVICE INCLUDING PARTITION WALL**

(30) Priority: 02.11.2023 KR 20230150144; 01.12.2023 KR 20230172525
(71) Applicant: Samsung Electronics Co., Ltd, Suwon-si, Gyeonggi-do 16677 (KR)
(72) Inventor: PARK, Haesung, Suwon-si, Gyeonggi-do 16677 (KR); KIM, Sangbae, Suwon-si, Gyeonggi-do 16677 (KR); SEOL, Moonseok, Suwon-si, Gyeonggi-do 16677 (KR)
(74) Representative: Nederlandsch Octrooibureau
(86) International application number: PCT/KR2024/017082
(87) International publication number: WO 2025/095698

(57) **Abstract**

An electronic device according to various embodiments of the disclosure may include a frame including a first seating surface and a second seating surface, a partition wall disposed to extend in a first direction on a boundary between the first seating surface and the second seating surface so as to be spaced apart from the first seating surface and the second seating surface in a second direction perpendicular to the first seating surface and the second seating surface, and a heat dissipation member disposed on the first seating surface and extending between the partition wall and the frame onto the second seating surface.

## Description

### [Technical Field]

The disclosure relates to an electronic device and, more particularly, to an electronic device including a partition wall.

### [Background Art]

An electronic device may include a frame that supports components inside the electronic device. The frame may include a partition wall that fixes respective components disposed on the frame and prevents collisions between the plurality of components.

The electronic device may include components that generate heat when the electronic device operates, such as an application processor (AP), a graphics processing unit (GPU), a neural processing unit (NPU), or a battery. The heat from the components that generate heat may increase the temperature in the electronic device, which may cause performance degradation, reduced lifespan, malfunction, and/or damage to the components of the electronic device.

The electronic device may include a heat dissipation member configured to disperse heat generated from the components described above over a wide area of the frame and release the heat to the outside of the electronic device. The heat dissipation member may be disposed between the above-described components that generate heat and the frame so as to be in contact with the components that generate heat and the frame, respectively.

### [Disclosure of Invention]

### [Solution to Problem]

When arranging a heat dissipation member in an electronic device, the area of the heat dissipation member may be limited due to partition walls positioned between the respective components. For example, if a partition wall exists around an area where a circuit board assembly of a frame is disposed, the expansion of the area of the heat dissipation member disposed between the circuit board assembly and the frame may be blocked by the partition wall, thereby limiting the improvement of the heat dissipation performance of the electronic device.

According to various embodiments of the disclosure, there may be provided an electronic device having a partition wall structure that facilitates the expansion of the area of the heat dissipation member.

An electronic device according to various embodiments of the disclosure may include a frame including a first seating surface and a second seating surface, a partition wall disposed to extend in a first direction on a boundary between the first seating surface and the second seating surface so as to be spaced apart from the first seating surface and the second seating surface in a second direction perpendicular to the first seating surface and the second seating surface, and a heat dissipation member disposed on the first seating surface and extending between the partition wall and the frame onto the second seating surface.

A circuit board assembly according to various embodiments of the disclosure may include a partition wall that is disposed at one end of the circuit board assembly and includes a substrate coupling portion to be coupled to the one end.

According to various embodiments of the disclosure, there is provided an electronic device in which a gap is formed between the partition wall and the frame and the heat dissipation member extends through the gap, thereby improving the area of the heat dissipation member and the heat dissipation performance thereof.

### [Brief Description of Drawings]

FIG. 1 is a block diagram of an electronic device in a network environment according to various embodiments.
FIG. 2A, FIG. 2B, FIG. 2C, FIG. 2D, and FIG. 2E are diagrams illustrating an electronic device according to various embodiments of the disclosure.
FIG. 3A is a plan view illustrating the inside of an electronic device according to various embodiments of the disclosure.
FIG. 3B is a plan view illustrating a frame of an electronic device according to various embodiments of the disclosure.
FIG. 3C is an exploded perspective view of an electronic device according to various embodiments of the disclosure.
FIG. 3D is a cross-sectional view of an electronic device according to various embodiments of the disclosure.
FIG. 4A is a perspective view illustrating a partition wall of an electronic device according to various embodiments of the disclosure.
FIG. 4B and FIG. 4C are perspective views illustrating coupling of a partition wall and a frame of an electronic device according to various embodiments of the disclosure.
FIG. 5A is a perspective view illustrating a heat dissipation member and a partition wall of an electronic device according to various embodiments.
FIG. 5B is an enlarged plan view illustrating a heat dissipation member and a partition wall of an electronic device according to various embodiments.
FIG. 5C is a cross-sectional view of an electronic device according to various embodiments.
FIG. 6A is a perspective view illustrating a circuit board assembly and a partition wall of an electronic device according to various embodiments.
FIG. 6B is a cross-sectional view of an electronic device according to various embodiments.
FIG. 6C is a schematic diagram illustrating an operation of coupling a circuit board assembly and a partition wall.

### [Mode for the Invention]

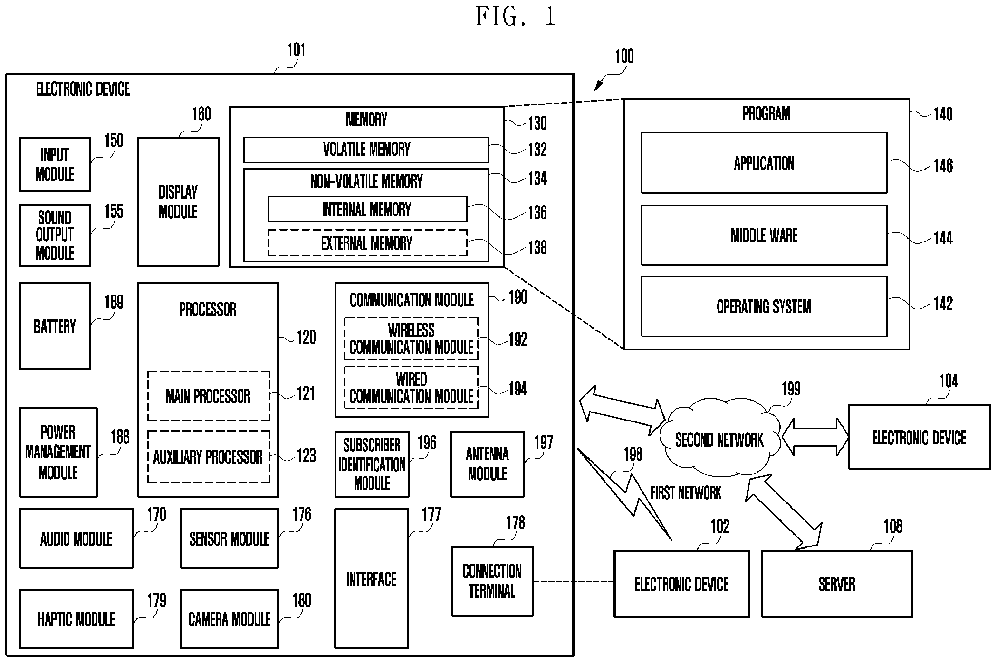

Fig. 1 is a block diagram illustrating an electronic device 101 in a network environment 100 according to various embodiments. Referring to Fig. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thererto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BluetoothTM, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197. According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStoreTM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

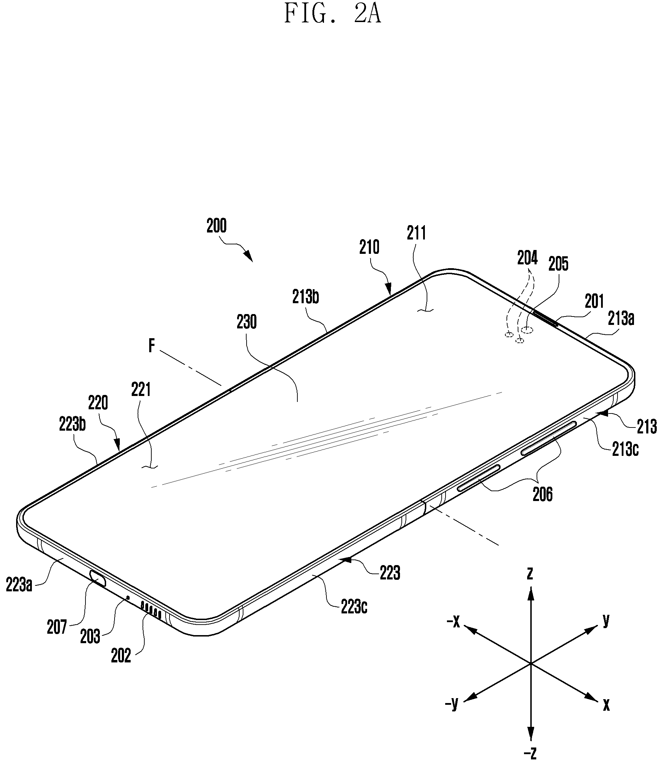

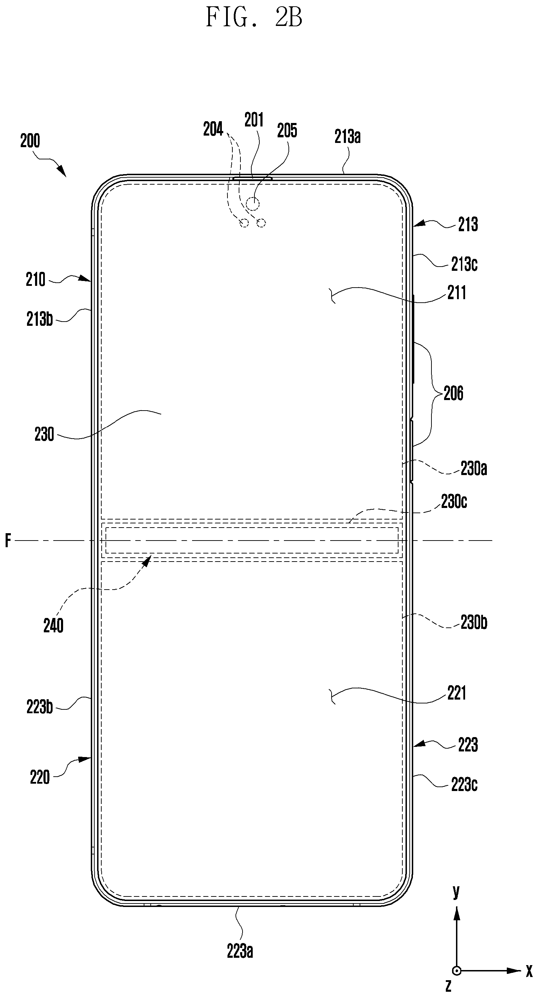

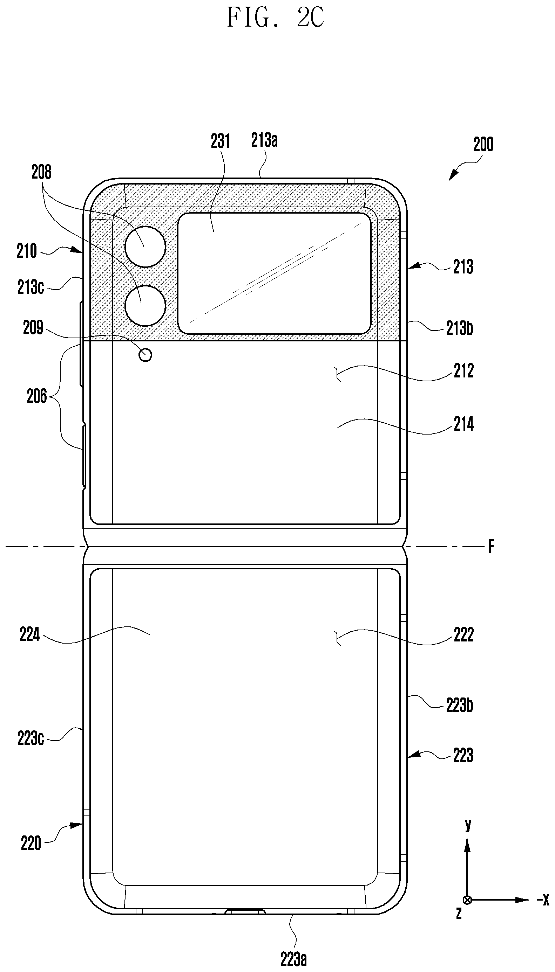

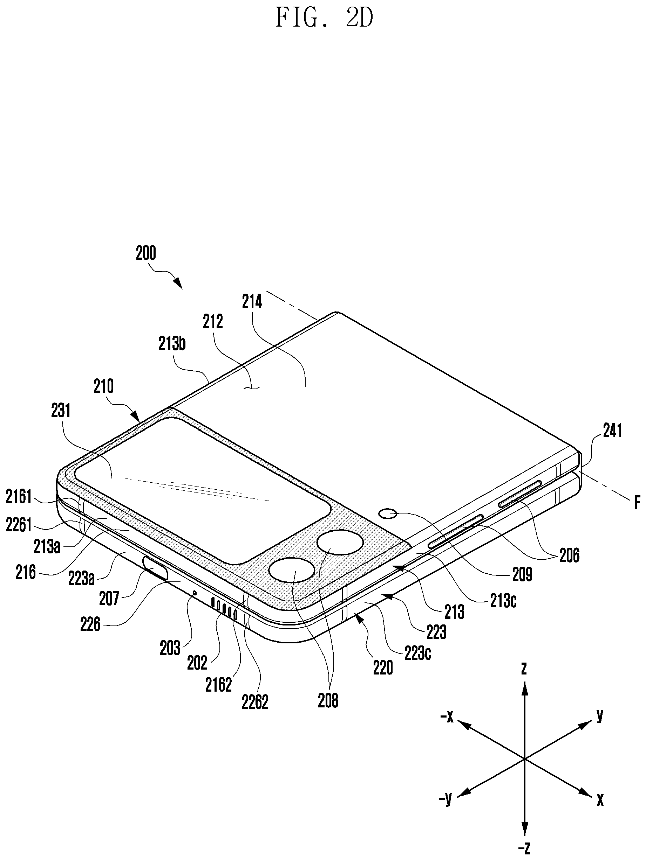

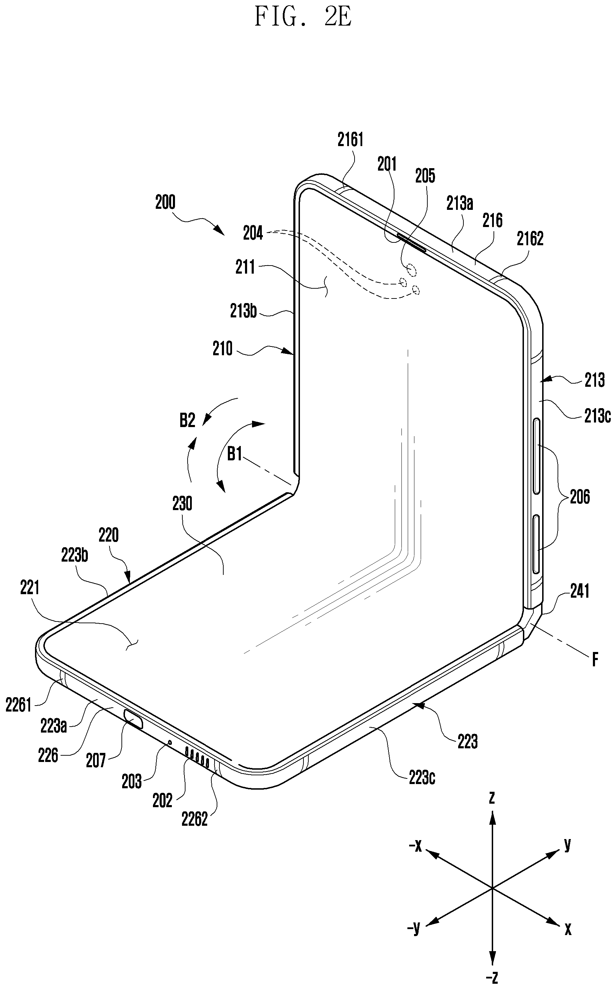

FIGS. 2A, 2B, 2C, 2D, and 2E are diagrams illustrating an electronic device 200 according to an embodiment of the disclosure.

FIG. 2A is a perspective view of an electronic device illustrating an unfolded state (or flat state) of the electronic device according to an embodiment of the disclosure. FIG. 2B is a plan view illustrating a front surface of an electronic device in an unfolded state of the electronic device according to an embodiment of the disclosure. FIG. 2C is a plan view illustrating a rear surface of an electronic device in an unfolded state according to an embodiment of the disclosure. FIG. 2D is a perspective view of an electronic device illustrating a folded state of the electronic device according to an embodiment of the disclosure. FIG. 2E is a perspective view of an electronic device illustrating an intermediate state of the electronic device according to an embodiment of the disclosure.

With reference to FIGS. 2A to 2E, an electronic device 200 may include first and second housings 210 and 220 (e.g., foldable housing structure) combined with each other in a foldable manner based on a hinge device (e.g., hinge device 240 of FIG. 2B). In an embodiment, the hinge device (e.g., hinge device 240 of FIG. 2B) may be disposed in an X-axis direction or in a Y-axis direction. According to an embodiment, the electronic device 200 may include a first display 230 (e.g., flexible display, foldable display, or main display) disposed in an area (e.g., recess) formed by the first and second housings 210 and 220. According to an embodiment, the first housing 210 and the second housing 220 may be disposed on both sides around a folding axis F, and may have a substantially symmetrical shape about the folding axis F. According to an embodiment, an angle or a distance between the first housing 210 and the second housing 220 may differ depending on the state of the electronic device 200. For example, depending on whether the electronic device is in an unfolded state (or flat state), in a folded state, or in an intermediate state, the angle or the distance between the first housing 210 and the second housing 220 may differ.

According to an embodiment, in the unfolded state of the electronic device 200, the first housing 210 may include a first surface 211 directed in a first direction (e.g., front direction) (z-axis direction), and a second surface 212 directed in a second direction (e.g., rear direction) (-z-axis direction) opposite to the first surface 211. According to an embodiment, in the unfolded state of the electronic device 200, the second housing 220 may include a third surface 221 directed in the first direction (z-axis direction), and a fourth surface 222 directed in the second direction (-z-axis direction). According to an embodiment, in the unfolded state of the electronic device 100, the first surface 211 of the first housing 210 and the third surface 221 of the second housing 220 may be directed in substantially the same first direction (z-axis direction). In an embodiment, in the folded state of the electronic device 200, the first surface 211 of the first housing 210 and the third surface 221 of the second housing 220 may face each other. According to an embodiment, in the unfolded state of the electronic device 200, the second surface 212 of the first housing 210 and the fourth surface 222 of the second housing 220 may be directed in substantially the same second direction (-z-axis direction). In an embodiment, in the folded state of the electronic device 200, the second surface 212 of the first housing and the fourth surface 222 of the second housing 220 may be directed in opposite directions. For example, in the folded state of the electronic device 200, the second surface 212 may be directed in the first direction (z-axis direction), and the fourth surface 222 may be directed in the second direction (-z-axis direction). In this case, the first display 230 may not be viewed from outside (in-folding manner). In an embodiment, the electronic device 200 may be folded so that the second surface 212 of the first housing 210 and the fourth surface 222 of the second housing 220 face each other. In this case, the first display 230 may be disposed to be viewed from the outside (out-folding manner).

According to an embodiment, the first housing 210 (e.g., first housing structure) may include a first lateral member 213 forming the appearance of the electronic device 200, and a first rear cover 214 combined with the first lateral member 213, and forming at least a part of the second surface 212 of the electronic device 200. According to an embodiment, the first lateral member 213 may include a first side surface 213a, a second side surface 213b extending from one end of the first side surface 213a, and a third side surface 213c extending from the other end of the first side surface 213a. According to an embodiment, the first lateral member 213 may be formed in a quadrangular (e.g., square or rectangular) shape through the first side surface 213a, the second side surface 213b, and the third side surface 213c.

According to an embodiment, the second housing 220 (e.g., second housing structure) may include a second lateral member 223 forming the appearance of the electronic device 200 at least partly, and a second lateral cover 224 combined with the second lateral member 223, and forming at least a part of the fourth surface 222 of the electronic device 200. According to an embodiment, the second lateral member 223 may include a fourth side surface 223a, a fifth side surface 223b extending from one end of the fourth side surface 223a, and a sixth side surface 223c extending from the other end of the fourth side surface 223a. According to an embodiment, the second lateral member 223 may be formed in a quadrangular shape through the fourth side surface 223a, the fifth side surface 223b, and the sixth side surface 223c.

According to an embodiment, the first and second housings 210 and 220 are not limited to the illustrated shapes and combinations, but may be implemented by combinations and/or compositions of other shapes or components. In an embodiment, the first lateral member 213 may be integrally formed with the first rear cover 214, and the second lateral member 223 may be integrally formed with the second rear cover 224.

According to an embodiment, in the unfolded state of the electronic device 200, the second side surface 213b of the first lateral member 213 and the fifth side surface 223b of the second lateral member 223 may be connected to each other without a gap. According to an embodiment, in the unfolded state of the electronic device 200, the third side surface 213c of the first lateral member 213 and the sixth side surface 223c of the second lateral member 223 may be connected to each other without a gap. According to an embodiment, in the unfolded state of the electronic device 200, the sum of the lengths of the second side surface 213b and the fifth side surface 223b may be configured to be longer than the length of the first side surface 213a and/or the fourth side surface 223a. According to an embodiment, in the unfolded state of the electronic device 200, the sum of the lengths of the third side surface 213c and the sixth side surface 223c may be configured to be longer than the length of the first side surface 213a and/or the fourth side surface 223a.

With reference to FIGS. 2D and 2E, the first lateral member 213 and/or the second lateral member 223 may be formed of metal, or may further include polymer that is injected into metal. According to an embodiment, the first lateral member 213 and/or the second lateral member 223 may include at least one conductive part 216 and/or 226 electrically segmented through at least one segment part 2161, 2162 and/or 2261, 2262 formed of polymer. In this case, the at least one conductive part 216 and/or 226 may be electrically connected to a wireless communication circuit included in the electronic device 200, and thus may be used as at least a part of an antenna that operates in at least one designated band (e.g., legacy band).

According to an embodiment, the first rear cover 214 and/or the second rear cover 224 may be formed of, for example, at least one of coated or colored glass, ceramic, polymer, or metal (e.g., aluminum, stainless steel (STS), or magnesium) or a combination of at least two thereof.

According to an embodiment, the first display 230 may be disposed to extend from the first surface 211 of the first housing 210 to at least a part of the third surface 221 of the second housing 220 across the hinge device (e.g., hinge device 240 of FIG. 2B). **In an** embodiment, the first display 230 may include a first area 230a substantially corresponding to the first surface 211, a second area 230b corresponding to the second surface 221, and a third area 230c (e.g., flexible area or folding area) connecting the first area 230a and the second area 230b to each other. According to an embodiment, the third area 230c may be a part of the first area 220a and/or the second area 230b, and may be disposed at a location corresponding to the hinge device (e.g., hinge device 240 of FIG. 2B). According to an embodiment, the electronic device 200 may include a hinge housing 241 (e.g., hinge cover) supporting the hinge device (e.g., hinge device 240 of FIG. 2B). In an embodiment, the hinge housing 241 may be disposed to be exposed to outside when the electronic device 200 is in a folded state, and not to be viewed from the outside as being drawn into an inner space of the first housing 210 and an inner space of the second housing 220 when the electronic device 200 is in an unfolded state.

According to an embodiment, the electronic device 200 may include a second display 231 (e.g., sub-display) disposed separately from the first display 230. According to an embodiment, the second display 231 may be disposed to be exposed at least partly on the second surface 212 of the first housing 210. In an embodiment, when the electronic device 200 is in the folded state, the second display 231 may display at least a part of state information of the electronic device 200 in replacement of at least a part of a display function of the first display 230. According to an embodiment, the second display 231 may be disposed to be viewed from the outside through at least a partial area of the first rear cover 214. In an embodiment, the second display 231 may be disposed on the fourth surface 222 of the second housing 220. In this case, the second display 231 may be disposed to be viewed from the outside through at least a partial area of the second rear cover 224.

According to an embodiment, the electronic device 200 may include at least one of an input device 203 (e.g., microphone), sound output devices 201 and 202, a sensor module 204, camera devices 205 and 208, a key input device 206, or a connector port 207. In an illustrated embodiment, although the input device 203 (e.g., microphone), the sound output devices 201 and 202, the sensor module 204, the camera devices 205 and 208, the key input device 206, or the connector port 207 are illustrated as hole or circular shaped elements formed on the first housing 210 or the second housing 220, they are exemplarily illustrated for explanation, but are not limited thereto. According to an embodiment, the input device 203 may include at least one microphone 203 disposed on the second housing 220. In an embodiment, the input device 203 may include a plurality of microphones 203 disposed to sense the sound direction. In an embodiment, the plurality of microphone 203 may be disposed at proper locations on the first housing 210 and/or the second housing 220. According to an embodiment, the sound output devices 201 and 202 may include at least one speaker 201 and 202. According to an embodiment, the at least one speaker 201 and 202 may include a receiver 201 for call disposed on the first housing 210, and the speaker 202 disposed on the second housing 220. In an embodiment, the input device 203, the sound output devices 201 and 202, and the connector port 207 may be disposed in a space provided in the first housing 210 and/or the second housing 220 of the electronic device 200, and may be exposed to an external environment through at least one hole formed on the first housing 210 and/or the second housing 220. According to an embodiment, the at least one connector port 207 may be used to transmit and receive power and/or data to and from an external electronic device. In an embodiment, the at least one connector port (e.g., ear jack hole) may accommodate a connector (e.g., ear jack) for transmitting and receiving an audio signal to and from the external electronic device. In an embodiment, the hole formed on the first housing 210 and/or the second housing 220 may be commonly used for the input device 203 and the sound output devices 201 and 202. In an embodiment, the sound output devices 201 and 202 may include a speaker (e.g., piezo-electric speaker) that is not exposed through the hole formed on the first housing 210 and/or the second housing 220.

According to an embodiment, the sensor module 204 may generate an electrical signal or a data value corresponding to an internal operation state of the electronic device 200 or an external environment state. According to an embodiment, the sensor module 204 may detect the external environment through the first surface 211 of the first housing 210. In an embodiment, the electronic device 200 may further include at least one sensor module disposed to detect the external environment through the second surface 212 of the first housing 210. According to an embodiment, the sensor module 204 (e.g., illumination sensor) may be disposed to detect the external environment through the first display 230 under the first display 230. According to an embodiment, the sensor module 204 may include at least one of a gesture sensor, a gyro sensor, a barometric pressure sensor, a magnetic sensor, an acceleration sensor, a grip sensor, a color sensor, an infrared (IR) sensor, a biosensor, a temperature sensor, a humidity sensor, an illumination sensor, a proximity sensor, a biosensor, an ultrasonic sensor, or an illumination sensor 204.

According to an embodiment, the camera devices 205 and 208 may include the first camera device 205 (e.g., front camera device) disposed on the first surface 211 of the first housing 210, and the second camera device 208 disposed on the second surface 212 of the first housing 210. In an embodiment, the electronic device 200 may further include a flash 209 disposed near the second camera device 208. According to an embodiment, the camera devices 205 and 208 may include at least one lens, an image sensor, and/or an image signal processor. According to an embodiment, the camera devices 205 and 208 may be disposed so that two or more lenses (e.g., wide angle lens, ultra wide angle lens, or telephoto lens) and two or more image sensors are located on one surface (e.g., first surface 211, second surface 212, third surface 221, or fourth surface 222) of the electronic device 200. In an embodiment, the camera devices 205 and 208 may include lenses for time of flight (TOF) and/or image sensors.

According to an embodiment, the key input device 206 (e.g., key buttons) may be disposed on the third side surface 213c of the first lateral member 213 of the first housing 210. **In** an embodiment, the key input device 206 may be disposed on at least one side surface of other side surfaces 213a and 213b of the first housing 210 and/or side surfaces 223a, 223b, and 223c of the second housing 220. In an embodiment, the electronic device 200 may not include some or all of the key input devices 206, and the non-included key input device 206 may be implemented in another form, such as a soft key, on the first display 230. In an embodiment, the key input device 206 may be implemented by using the pressure sensor included in the first display 230.

According to an embodiment, one of the camera devices 205 and 208 (e.g., first camera device 205) or the sensor module 204 may be disposed to be exposed through the first display 230. According to an embodiment, the first camera device 205 or the sensor module 204 may be optically exposed to the outside through an opening (e.g., through-hole) formed at least partly on the first display 230 in the inner space of the electronic device 200. According to an embodiment, at least a part of the sensor module 204 may be disposed not to be visually exposed through the first display 230 in the inner space of the electronic device 200. With reference to FIG. 2E, the electronic device 200 may operate to maintain at least one designated folding angle in an intermediate state through the hinge device (e.g., hinge device 240 of FIG. 2B). In this case, the electronic device 200 may control the first display 230 so that different kinds of content are displayed on the display area corresponding to the first surface 211 and the display area corresponding to the third surface 221. According to an embodiment, the electronic device 200 may operate in substantially the unfolded state (e.g., unfolded state of FIG. 2A) and/or in substantially the folded state (e.g., folded state of FIG. 2D) based on a specific folding angle (e.g., angle between the first housing 210 and the second housing 220 when the electronic device 200 is in the intermediate state) through the hinge device (e.g., hinge device 240 of FIG. 2B). In an embodiment, if a pressing force is provided in an unfolding direction (direction B1) in a state where the electronic device 200 is unfolded at the specific folding angle through the hinge device (e.g., hinge device 240 of FIG. 2B), the electronic device 200 may operate to be transitioned to the unfolded state (e.g., unfolded state of FIG. 2A). In an embodiment, if the pressing force is provided in a folding direction (direction B2) in a state where the electronic device 200 is unfolded at the specific folding angle through the hinge device (e.g., hinge device 240 of FIG. 2B), the electronic device 200 may operate to be transitioned to the folded state (e.g., folded state of FIG. 2D). In an embodiment, the electronic device 200 may operate to maintain the unfolded state (not illustrated) at various angles through the hinge device (e.g., hinge device 240 of FIG. 2B) (free-stop function).

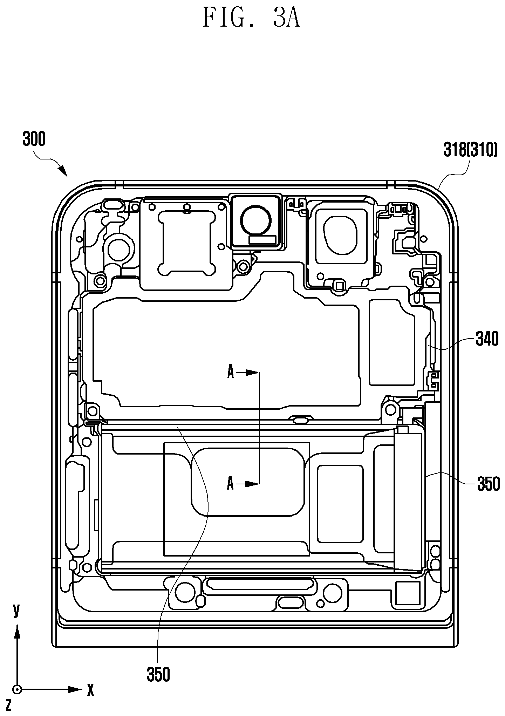

FIG. 3A is a plan view illustrating the inside of an electronic device 300 according to various embodiments of the disclosure.

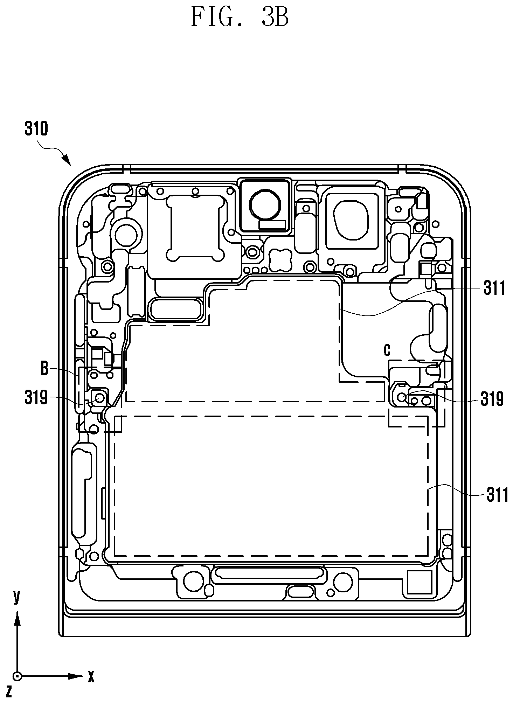

FIG. 3B is a plan view illustrating a frame 310 of an electronic device 300 according to various embodiments of the disclosure.

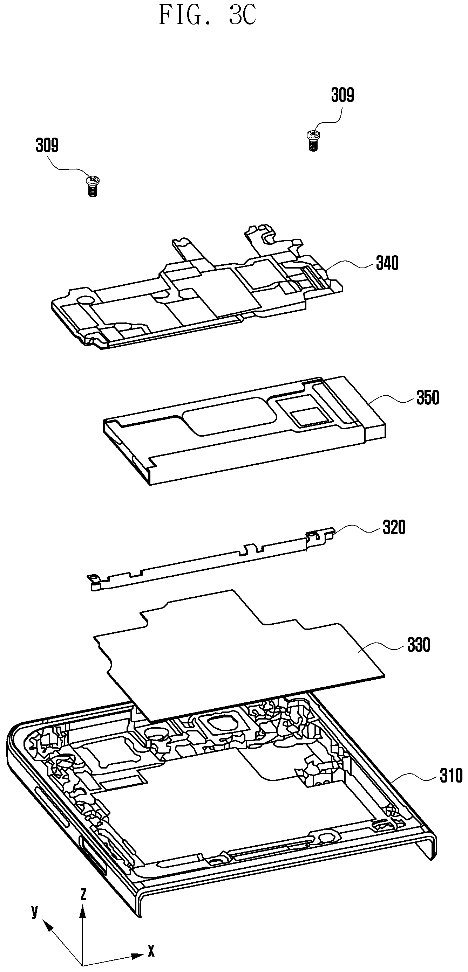

FIG. 3C is an exploded perspective view of an electronic device 300 according to various embodiments of the disclosure.

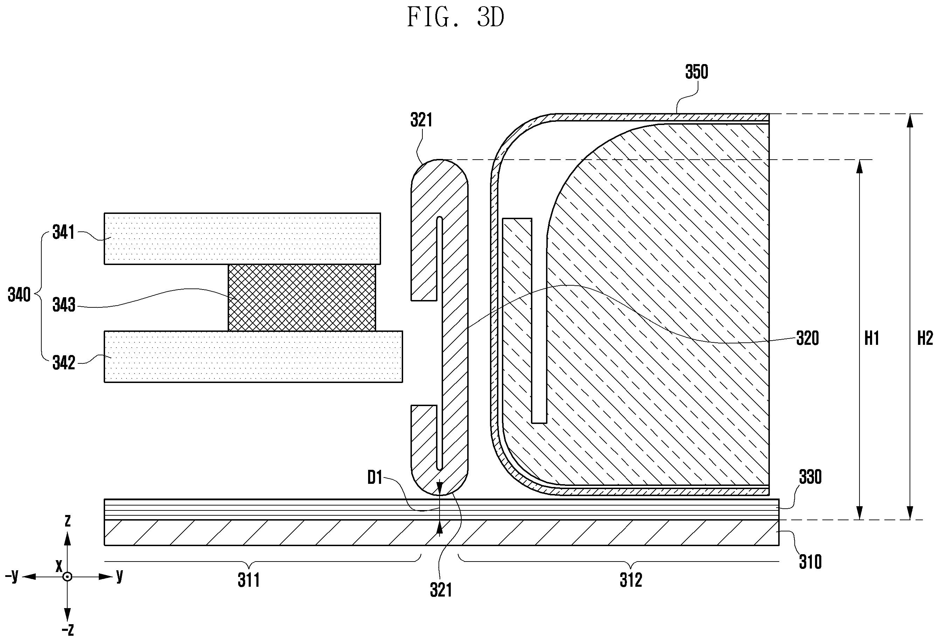

FIG. 3D is a cross-sectional view of an electronic device 300 according to various embodiments of the disclosure.

FIG. 3D is a cross-section view taken along line A-A in FIG. 3A.

Referring to FIGS. 3A and 3C, an electronic device 300 (e.g., the electronic device 101 in FIG. 1 or the electronic device 200 in FIGS. 2A to 2E) according to various embodiments of the disclosure may include a frame 310, a circuit board assembly 340, a battery 350, and a partition wall 320.

The frame 310 may be a member that supports internal components of the electronic device 300, such as the circuit board assembly 340 and the battery 350, and provides a space for the components to be installed. In various embodiments, the frame 310 may be integrally formed with or coupled to the side member 318 (e.g., the first side member 213 and/or the second side member 223 in FIGS. 2A to 2E) of the electronic device 300.

The circuit board assembly 340 may include one or more circuit boards (e.g., the upper board 341 and the lower board 342) and one or more electrical components 343 disposed thereon. The circuit board may be a member that electrically connects the electrical components 343 disposed on the circuit board to each other. The circuit board assembly 340 may also be referred to as a printed board assembly (PBA).

The battery 350 may be a member that stores and provides power required for the operation of the electronic device 300. The battery 350 may include, for example, a jelly roll-type lithium ion battery. The battery 350 may be located in one area (e.g., a second seating surface 312) of the frame 310.

The partition wall 320 (also referred to as a bulkhead) may be a member that is located between various components (e.g., the circuit board assembly 340 and/or the battery 350) arranged inside the electronic device 300 to reduce or prevent contact and/or collision between the various components. For example, the partition wall 320 may restrict movement of the components inside the electronic device 300 and prevent collision between the components when acceleration and/or impact is applied from outside the electronic device 300. In various embodiments, the partition wall 320 may extend in a first direction (e.g., the x-axis direction). In various embodiments, the electronic device 300 may include a fastener 309 (e.g., screw) for fixing the partition wall 320. In various embodiments, a dimension (this may be referred to as a "height") H1 of the partition wall 320 from the frame 310 in a second direction (e.g., the z-axis direction) perpendicular to a first seating surface 311 and a second seating surface 312 may be 75% or more of the height H2 of the battery 350. Therefore, the partition wall 320 may effectively restrict the movement and collision of components such as the battery 350.

Referring to FIG. 3B, the frame 310 of the electronic device 300 may include a first seating surface 311 and a second seating surface 312. The first seating surface 311 may be a portion where an inner component of the electronic device 300, such as a circuit board assembly 340, is positioned. For example, the circuit board assembly 340 may be positioned to overlap the first seating surface 311 when viewed in the second direction (e.g., the z-axis direction in the drawing). For example, a heat dissipation member 330 may be disposed on the first seating surface 311 of the frame 310, and the circuit board assembly 340 may be disposed on the heat dissipation member 330. For example, the heat dissipation member 330 may be disposed between the first seating surface 311 of the frame 310 and the circuit board assembly 340.

A component such as the battery 350 may be positioned on the second seating surface 312. For example, the battery 350 may be disposed to overlap the second seating surface 312, which will be described later, when viewed in the second direction (e.g., the z-axis direction in the drawing). For example, a heat dissipation member 330, which will be described later, may be disposed on the second seating surface 312 of the frame 310, and the battery 350 may be disposed on the heat dissipation member 330. For example, the heat dissipation member 330 may be disposed between the second seating surface 312 of the frame 310 and the battery 350.

The first and second seating surfaces 312 may be positioned substantially on the same plane. For example, the frame 310 may include a recess formed to have a surface perpendicular to the second direction (e.g., the z-axis direction in the drawing), and areas on the inner surface of the recess may be defined as the first seating surface 311 and the second seating surface 312.

Referring to FIGS. 3C and 3D, the electronic device 300 may include a heat dissipation member 330. The heat dissipation member 330 may be a member that disperses heat generated from the electronic device 300 (e.g., an application processor (AP), a memory (e.g., the memory 130 in FIG. 1), and/or the battery 350) to reduce or prevent a temperature rise in a specific part of the electronic device 300 and to allow heat to be released from a wider surface of the electronic device 300, thereby improving the heat dissipation performance of the electronic device 300.

In various embodiments, the heat dissipation member 330 may include a material having high thermal conductivity, such as a metal (e.g., copper, gold, silver, and/or aluminum), carbon fiber (e.g., a graphite sheet), diamond, and/or silicon. In various embodiments, the heat dissipation member 330 may include a structure having high thermal conductivity, such as a heat pipe and/or a vapor chamber.

Referring to FIG. 3D, in various embodiments, the partition wall 320 may be spaced apart from the frame 310. For example, the partition wall 320 may be spaced by a first gap D1 apart from the plane constituting the first seating surface 311 and the second seating surface 312 of the frame 310 in the second direction (e.g., in the z-axis direction). The first gap D1 may be sized so as to provide enough space for the heat dissipation member 330 to pass through. For example, the first gap D1 may be approximately between 0.1 and 10 millimeters. The heat dissipation member 330 may be disposed on the first seating surface 311 and may pass below the partition wall 320 through the first gap, thereby extending to the second seating surface 312. As the heat dissipation member 330 extends from the first seating surface 311 to the second seating surface 312 by passing below the partition wall 320, the area of the heat dissipation member 330 may be expanded, and the heat generated from the substrate or the battery 350 may be distributed and released over a wider area, thereby improving the heat dissipation performance of the electronic device 300.

In various embodiments, the partition wall 320 may include a rigid reinforcement portion 321. The rigid reinforcement portion 321 may be, for example, a portion formed by bending the end of the partition wall 320 directed to the second direction (e.g., the z-axis direction) and/or the opposite direction (e.g., the -z-axis direction) of the second direction. Bending described above may improve the rigidity of the partition wall 320, so that the movement of components inside the electronic device 300 may be effectively restricted.

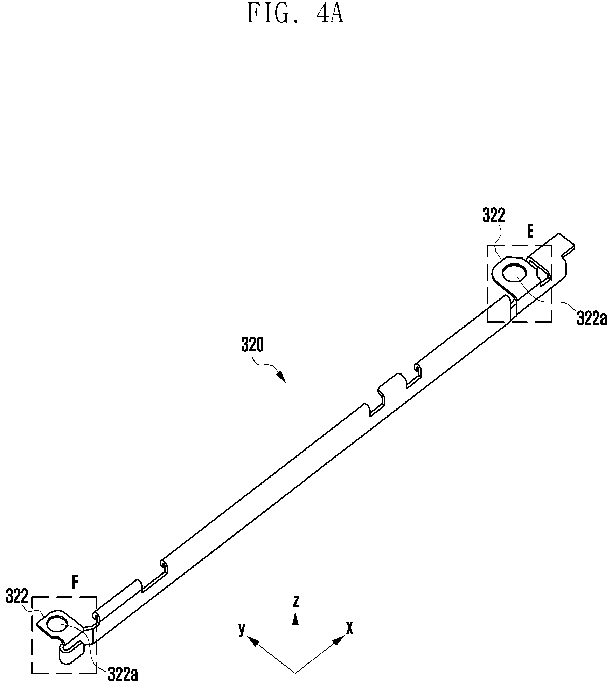

FIG. 4A is a perspective view illustrating a partition wall 320 of an electronic device 300 according to various embodiments of the disclosure.

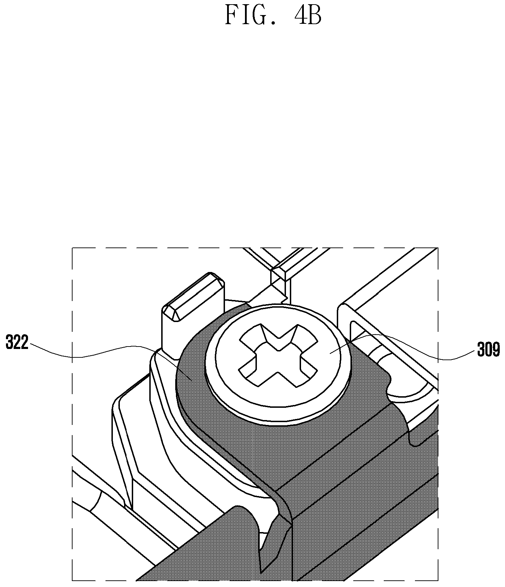

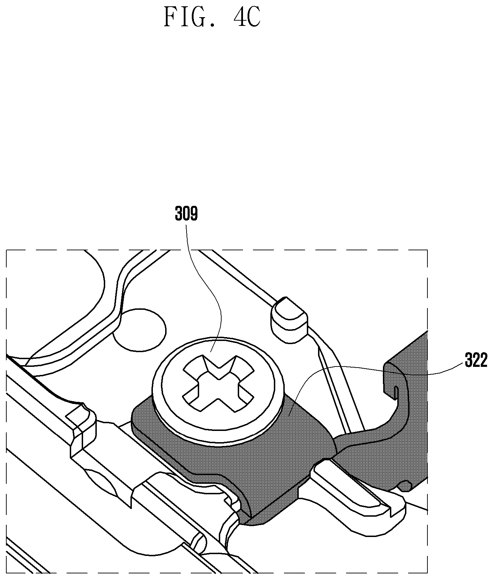

FIG. 4B and FIG. 4C are perspective views illustrating coupling of a partition wall 320 and a frame 310 of an electronic device 300 according to various embodiments of the disclosure.

FIG. 4B is an enlarged view of area B in FIG. 3B and area E of FIG. 4A, and FIG. 4C is an enlarged view of area C in FIG. 3B and area F of FIG. 4A.

Referring to FIG. 4A, the partition wall 320 according to various embodiments may include fastening portions 322 provided at both ends of the partition wall 320 (e.g., ends in the first direction (x-axis direction) and the opposite direction (-x-axis direction) of the first direction). In various embodiments, the fastening portion 322 may be fixed to the fastener 309 in order to fix the partition wall 320 to the frame 310. For example, the fastening portion 322 may include a fastening hole 322a formed to allow the fastener 309 to pass therethrough.

Referring back to FIGS. 3B, 4B, and 4C, the frame 310 may include a partition wall coupling portion 315. The partition wall coupling portion 315 may be located at both ends of a boundary line between the first seating surface 311 and the second seating surface 312 and configured such that the fastener 309 is fastened thereto. For example, the partition wall coupling portion 315 may include a tab hole 319 formed on the frame 310 such that the fastener 309 (e.g., screw) is fastened thereto. The partition wall 320 may be fixed to the frame 310 by fastening the fastening portion 322 to the partition wall coupling portion 315 by the fastener 309, thereby restricting mutual collision or movement of the components located on the first seating surface 311 and/or the second seating surface 312.

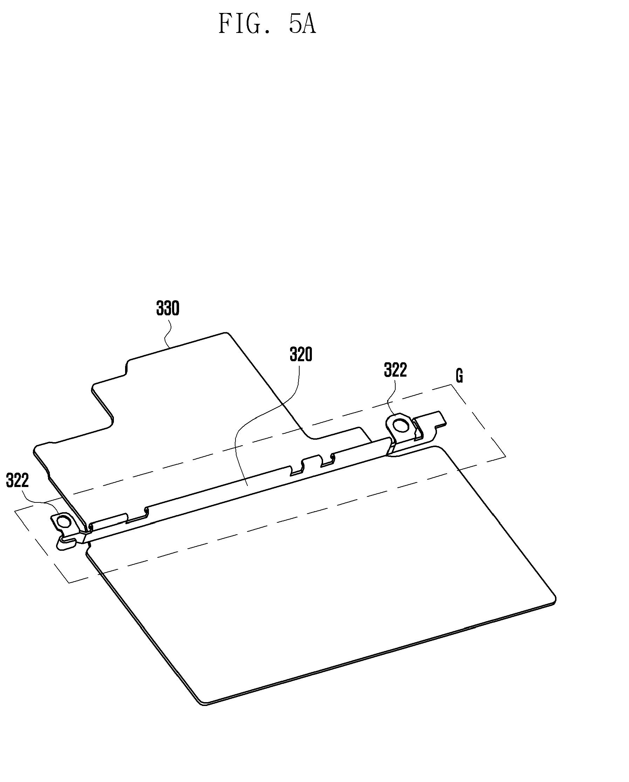

FIG. 5A is a perspective view illustrating a heat dissipation member 330 and a partition wall 320 of an electronic device 300 according to various embodiments.

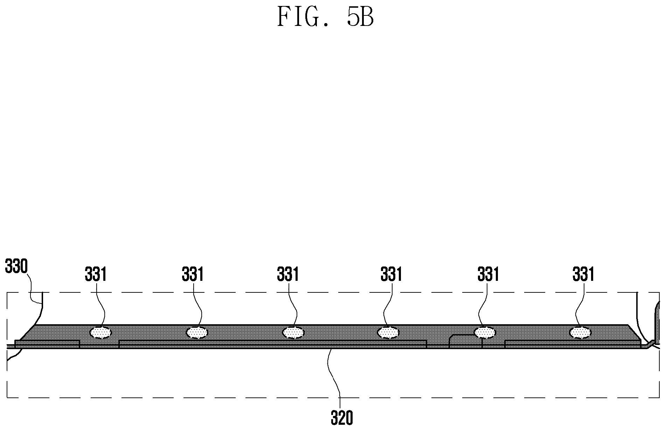

FIG. 5B is an enlarged plan view illustrating a heat dissipation member 330 and a partition wall 320 of an electronic device 300 according to various embodiments.

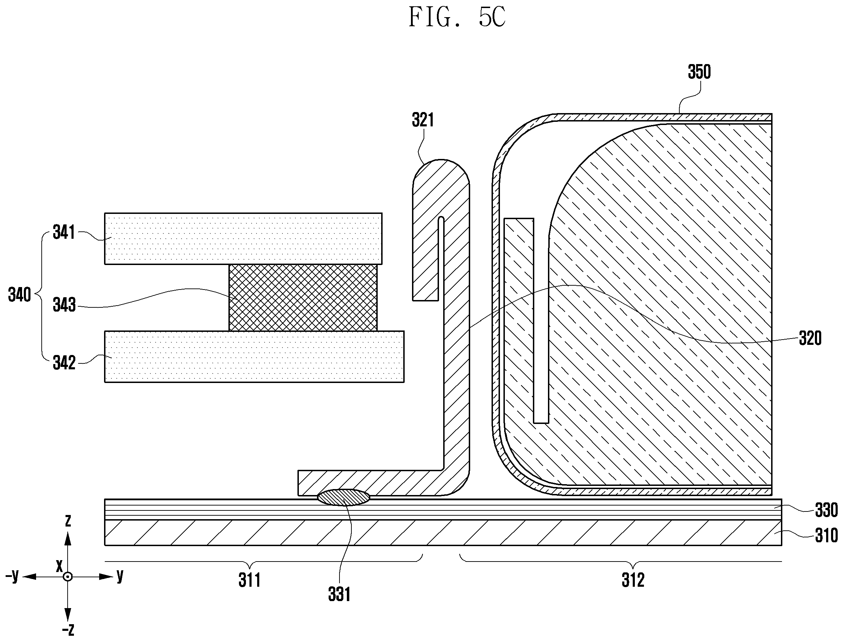

FIG. 5C is a cross-sectional view of an electronic device 300 according to various embodiments.

FIG. 5B is enlarged view of area G in FIG. 5A.

Referring to FIGS. 5A to 5C, the partition wall 320 may be coupled to the heat dissipation member 330. For example, the heat dissipation member 330 may include a metal material, and the partition wall 320 may be coupled onto the surface of the heat dissipation member 330 by fusing (e.g., soldering, brazing, and/or welding). In some embodiments, the partition wall 320 may be welded onto the surface of the heat dissipation member 330 by means of spot welding. Spot welding may fix the partition wall 320 to the heat dissipation member 330 without damaging the structure and thermal conductivity of the heat dissipation member 330 (e.g., vapor chamber). A plurality of spot welds 331 may be formed between the partition wall 320 and the heat dissipation member 330 by spot welding.

Since the partition wall 320 is coupled to the heat dissipation member 330, the operation of positioning the heat dissipation member 330 on the frame 310 and the operation of positioning the partition wall 320 may be performed as one operation when assembling the electronic device 300, so that the electronic device 300 may be assembled in a more efficient manner. In addition, when the heat dissipation member 330 is correctly disposed on the frame 310, the position of the partition wall 320 is also fixed, thereby reducing or preventing the defect of the partition wall 320 being displaced from the correct position.

The first and second seating areas 311, 312, the circuit board assembly 340, and the battery 350 depicted in FIG. 5C have already been described with reference to FIGS. 3A-3D.

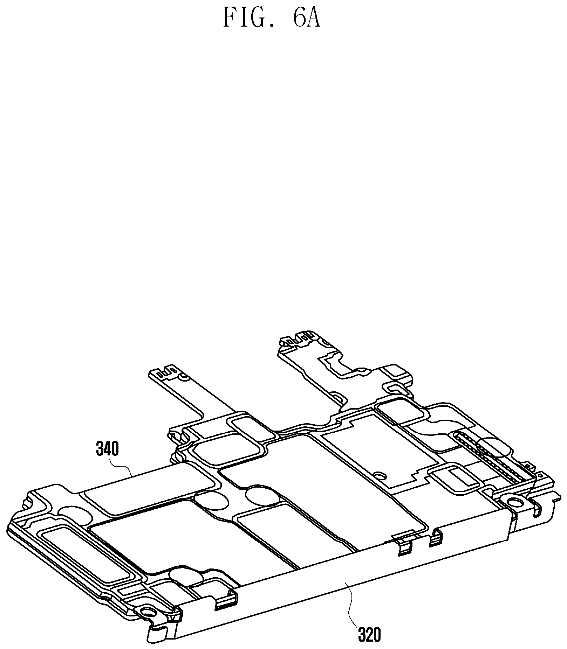

FIG. 6A is a perspective view illustrating a circuit board assembly 340 and a partition wall 320 of an electronic device 300 according to various embodiments.

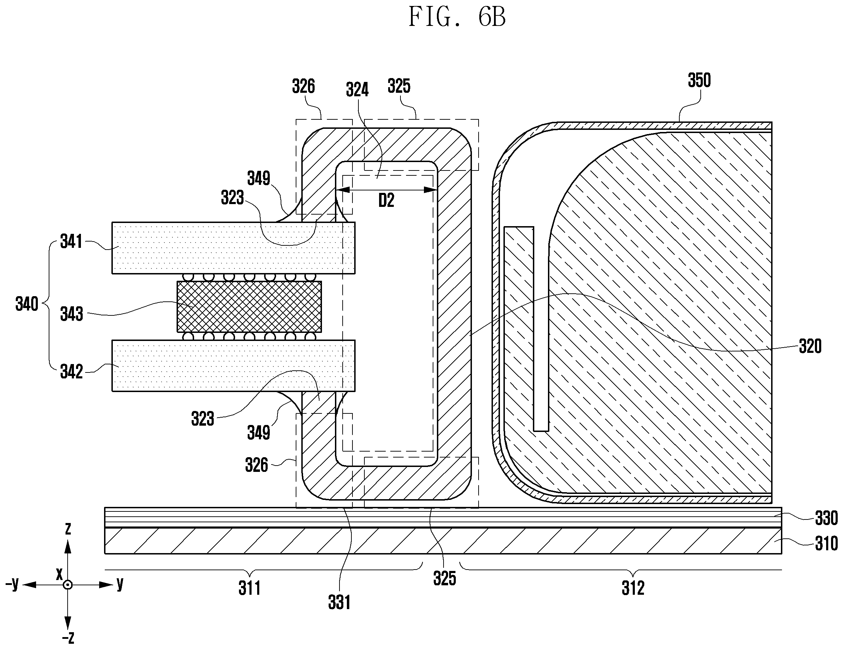

FIG. 6B is a cross-sectional view of an electronic device 300 according to various embodiments.

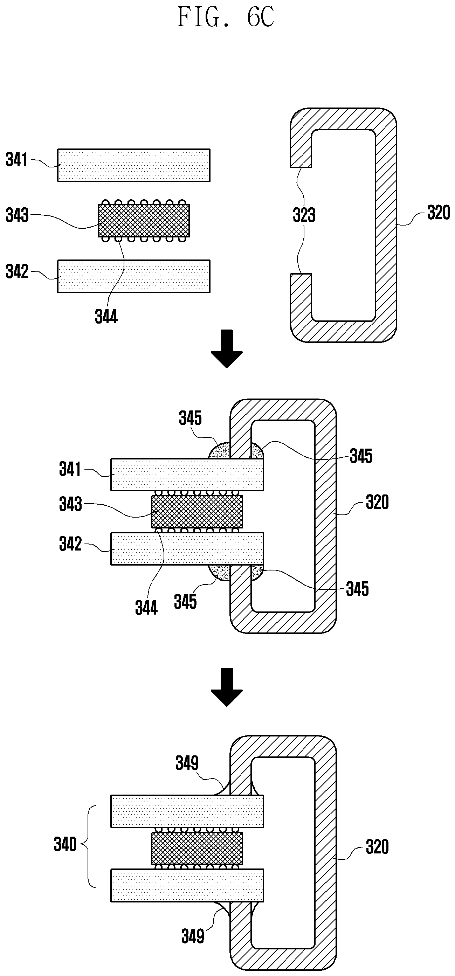

FIG. 6C is a schematic diagram illustrating an operation of coupling a circuit board assembly 340 and a partition wall 320.

Referring to FIG. 6A and FIG. 6B, the partition wall 320 may be coupled to the circuit board assembly 340. For example, the partition wall 320 may include a substrate coupling portion 323 to be coupled to the circuit board assembly 340. The partition wall 320 may be coupled to the circuit board assembly 340 by coupling the substrate coupling portion 323 to one side of the circuit board assembly 340. The partition wall 320 may be coupled to the circuit board assembly 340 by means such as soldering or surface mount technology (SMT). For example, the solder 349 may be positioned in an area where the substrate coupling portion 323 and the circuit board assembly 340 come into contact, and may fix the substrate coupling portion 323 of the partition wall 320 to the circuit board assembly 340.

Since the partition wall 320 is coupled to the circuit board assembly 340, the operation of positioning the circuit board assembly 340 on the frame 310 and the operation of positioning the partition wall 320 may be performed as one operation when assembling the electronic device 300, so that the electronic device 300 may be assembled in a more efficient manner and the incorrect assembly of the partition wall 320 may be prevented or reduced.

In various embodiments, the partition wall 320 may have an impact absorption space 324. The impact absorption space 324 may be a space that absorbs an impact applied in a third direction (e.g., the y-axis direction) toward the side of the circuit board assembly 340. For example, the partition wall 320 may include a first bent portion 325 formed by being bent in the third direction and a second bent portion 326 formed by bending the end of the first bent portion 325 (for example, in the -y-axis direction). A substrate coupling portion 323 may be provided at the end of the second bent portion 326. The first bent portion 325 and the second bent portion 326 may be spaced apart from each other by a second gap D2. As the first bent portion 325 and the second bent portion 326 are spaced apart from each other, an impact absorption space 324 may be formed in the partition wall 320. The second gap D2 defines the size of the impact absorption space 324 in the third direction (e.g. the y-axis direction). For example, the second gap D2 may be approximately between 0.1 and 10 millimeters.

As the partition wall 320 is coupled to the circuit board assembly 340, the impact applied to the partition wall 320 may be transmitted to the circuit board assembly 340. Therefore, since the partition wall 320 has the impact absorption space 324, the impact applied to the partition wall 320 may be at least partially absorbed by the impact absorption space 324, thereby reducing and/or eliminating the impact transmitted to the circuit board assembly 340.

Referring to FIG. 6C, the partition wall 320 may be coupled to the circuit board assembly 340 by SMT. The circuit board assembly 340 may include one or more electrical components 343 (e.g., active circuit components such as APs, PMICs, and DDIs, or passive circuit components such as resistors, inductors, and capacitors). In various embodiments, the circuit board assembly 340 may be manufactured by an operation of positioning the electrical components 343 and the partition wall 320 on a substrate (e.g., the upper substrate 341 and/or the lower substrate 342) and an operation of coupling the electrical components 343 and the partition wall 320 to the circuit board assembly 340 by SMT. In various embodiments, when manufacturing the circuit board assembly 340, solder paste 345 may be applied to an area where the circuit board assembly 340 and the substrate coupling portion 323 of the partition wall 320 come into contact. When the circuit board assembly 340 is heated to mount the electrical components 343 of the circuit board assembly 340 on the substrate (for example, to couple the electrical component 343 to the circuit board assembly 340 by melting the solder ball 344 of the electrical component 343), the solder paste 345 may melt or partially melt so that the partition wall 320 may be coupled to the circuit board assembly 340. Therefore, according to the above-described operation, the coupling of the circuit board assembly 340 and the partition wall 320 may be performed together with the SMT process of placing the electrical components 343 on the circuit board assembly 340, so that the time and cost required for manufacturing the electronic device 300 may be reduced and productivity may be improved.

An electronic device 300 according to various embodiments of the disclosure may include a frame 310 including a first seating surface 311 and a second seating surface 312, a partition wall 320 disposed to extend in a first direction on a boundary between the first seating surface 311 and the second seating surface 312 so as to be spaced apart from the first seating surface 311 and the second seating surface 312 in a second direction perpendicular to the first seating surface 311 and the second seating surface 312, and a heat dissipation member 330 disposed on the first seating surface 311 and the second seating surface 312, and disposed between the partition wall 320 and the frame 310.

An electronic device 300 according to various embodiments of the disclosure may include a frame 310 including a first seating surface 311 and a second seating surface 312, a partition wall 320 disposed to extend in a first direction on a boundary between the first seating surface 311 and the second seating surface 312 so as to be spaced apart from the first seating surface 311 and the second seating surface 312 in a second direction perpendicular to the first seating surface 311 and the second seating surface 312, and a heat dissipation member 330 disposed on the first seating surface 311 and extending between the partition wall 320 and the frame 310 onto the second seating surface 312.

In various embodiments, the partition wall 320 may include a fastening portion 322 formed at an end of the partition wall 320 in the first direction, and the frame 310 may include a partition wall coupling portion 315 to be coupled to the fastening portion 322, and the electronic device may include a fastener 309 configured to couple the fastening portion 322 to the partition wall coupling portion 315.

In various embodiments, the electronic device 300 may include a circuit board assembly 340 disposed to overlap the first seating surface 311 when viewed in the second direction, and the partition wall 320 may include a substrate coupling portion 323 to be coupled to the circuit board assembly 340.

In various embodiments, the partition wall 320 may be configured to have an impact absorption space 324 that absorbs an impact applied in a third direction perpendicular to the first direction and the second direction.

In various embodiments, the partition wall 320 may include a first bent portion 325 formed by bending an end of the partition wall 320 in a third direction perpendicular to the first direction and the second direction, and a second bent portion 326 formed by bending an end of the first bent portion 325 to be parallel to the second direction, and the substrate coupling portion 323 may be located at an end of the second bent portion 326.

In various embodiments, the first bent portion 325 and the second bent portion 326 may be spaced apart from each other by a second gap D2.

In various embodiments, the substrate coupling portion 323 may be coupled to the circuit board assembly 340 by soldering.

In various embodiments, the substrate coupling portion 323 may be coupled to the circuit board assembly 340 by surface mount technology (SMT).

In various embodiments, the electronic device 300 may include electrical components 343 disposed on the circuit board assembly 340, and the circuit board assembly 340 may be manufactured by an operation of coupling the partition wall 320 and the plurality of electrical components 343 to the circuit board assembly 340 by SMT.

In various embodiments, the partition wall 320 may include a rigid reinforcement portion 321.

In various embodiments, the rigid reinforcement portion 321 may be formed by bending an end of the partition wall 320 directed to the second direction.

In various embodiments, the heat dissipation member 330 may include a metal material, and the partition wall 320 may be bonded onto a surface of the heat dissipation member 330.

In various embodiments, the partition wall 320 may be bonded onto the surface of the heat dissipation member 330 by spot welding.

In various embodiments, the heat dissipation member 330 may include a vapor chamber.

In various embodiments, the electronic device 300 may include a battery 350 disposed to overlap the second seating surface 312 when viewed from the second direction, and the dimension from the frame 310 to an end of the partition wall 320 in the second direction may be 75% or more of the dimension from the frame 310 to an end of the battery 350 in the second direction.

A circuit board assembly 340 according to various embodiments of the disclosure may include a partition wall 320 that is disposed at one end of the circuit board assembly 340 and indicates a substrate coupling portion 323 to be coupled to the one end.

In various embodiments, the partition wall 320 may be configured to have an impact absorption space 324 that absorbs an impact applied in a third direction perpendicular to the first direction and the second direction.

In various embodiments, the circuit board assembly 340 may further include electrical components 343, and the circuit board assembly 340 may be manufactured by an operation of coupling the partition wall 320 and the electrical components 343 to the circuit board assembly 340 by SMT.

In various embodiments, the partition wall 320 may include a first bent portion 325 formed by bending an end of the partition wall 320 in a third direction perpendicular to the first direction and the second direction, and a second bent portion 326 formed by bending an end of the first bent portion 325 to be parallel to the second direction, and the substrate coupling portion 323 may be located at an end of the second bent portion 326.

In various embodiments, the first bent pot 325 and the second bent portion 326 may be spaced by a second gap D2 apart from each other.

In addition, the embodiments disclosed in this document disclosed in the specification and drawings are only specific examples presented to easily explain the technical subject matter according to the embodiments disclosed in this document and to help understand the embodiments disclosed in this document, and are not intended to limit the scope of the embodiments disclosed in this document. Therefore, the scope of the various embodiments disclosed in this document should be interpreted to include all changes or modifications derived based on the technical ideas of the various embodiments disclosed in this document, in addition to the embodiments disclosed herein.

## Claims

1. An electronic device (300) comprising:
a frame (310) comprising a first seating surface (311) and a second seating surface (312);
a partition wall (320) disposed to extend in a first direction parallel to a boundary between the first seating surface (311) and the second seating surface (312) so as to be spaced apart from the first seating surface (311) and the second seating surface (312) in a second direction perpendicular to the first seating surface (311) and the second seating surface (312); and
a heat dissipation member (330) disposed on the first seating surface (311) and extending between the partition wall (320) and the frame (310) onto the second seating surface (312).

2. The electronic device (300) of claim 1,
wherein the partition wall (320) comprises a fastening portion (322) formed at an end of the partition wall (320) in the first direction,
wherein the frame (310) comprises a partition wall coupling portion (315) to be coupled to the fastening portion (322), and
wherein the electronic device comprises a fastener (309) configured to couple the fastening portion (322) to the partition wall coupling portion (315).

3. The electronic device (300) of claim 1 or 2,
comprising a circuit board assembly (340) disposed to overlap the first seating surface (311) when viewed in the second direction,
wherein the partition wall (320) comprises a substrate coupling portion (323) to be coupled to the circuit board assembly (340).

4. The electronic device (300) of claim 3,
wherein the partition wall (320) comprises a first bent portion (325) formed by bending an end of the partition wall (320) in a third direction perpendicular to the first direction and the second direction, and a second bent portion (326) formed by bending an end of the first bent portion (325) to be parallel to the second direction, and
wherein the substrate coupling portion (323) is located at an end of the second bent portion (326).

5. The electronic device (300) of claim 4,
wherein the first bent portion (325) and the second bent portion (326) are spaced apart from each other by a second gap.

6. The electronic device (300) of any one of claims 3-5,
wherein the substrate coupling portion (323) is coupled to the circuit board assembly (340) by soldering.

7. The electronic device (300) of claim 1,
comprising electrical components (343) disposed on the circuit board assembly (340),
wherein the substrate coupling portion (323) is coupled to the circuit board assembly (340) by surface mount technology, SMT, and
wherein the circuit board assembly (340) is manufactured by an operation of coupling the partition wall (320) and the plurality of electrical components (343) to the circuit board assembly (340) by SMT.

8. The electronic device (300) of any one of the preceding claims,
wherein the partition wall (320) is configured to have an impact absorption space (324) configured to absorb an impact applied in a third direction perpendicular to the first direction and the second direction.

9. The electronic device (300) of claim 1 or 2,
wherein the partition wall (320) comprises a rigid reinforcement portion (321), and
wherein the rigid reinforcement portion (321) is formed by bending an end of the partition wall (320) directed to the second direction.

10. The electronic device (300) of any one of the preceding claims,
wherein the heat dissipation member (330) comprises a metal material, and
wherein the partition wall (320) is bonded onto a surface of the heat dissipation member (330).

11. The electronic device (300) of claim 10,
wherein the partition wall (320) is bonded onto the surface of the heat dissipation member (330) by spot welding.

12. The electronic device (300) of any one of the preceding claims,
wherein the heat dissipation member (330) comprises a vapor chamber.

13. The electronic device (300) of any one of the preceding claims,
further comprising a battery (350) disposed to overlap the second seating surface (312) when viewed from the second direction,
wherein the dimension from the frame (310) to an end of the partition wall (320) in the second direction is 75% or more of the dimension from the frame (310) to an end of the battery (350) in the second direction.

14. A circuit board assembly (340) of an electronic device (300), the circuit board assembly (340) comprising a partition wall (320) that is disposed at one end of the circuit board assembly (340) and comprises a substrate coupling portion (323) to be coupled to the one end.

15. An electronic device (300) comprising:
a frame (310) comprising a first seating surface (311) and a second seating surface (312);
a partition wall (320) disposed to extend in a first direction parallel to a boundary between the first seating surface (311) and the second seating surface (312) so as to be spaced apart from the first seating surface (311) and the second seating surface (312) in a second direction perpendicular to the first seating surface (311) and the second seating surface (312); and
a heat dissipation member (330) disposed on the first seating surface (311) and the second seating surface (312) and disposed between the partition wall (320) and the frame (310).
